Europäisches Patentamt

European Patent Office

Office européen des brevets

(19)

(11) Publication number: **0 028 654**

**B1**

(12) **EUROPEAN PATENT SPECIFICATION**

(45) Date of publication of patent specification: **15.01.86**

(21) Application number: **80900914.5**

(22) Date of filing: **17.05.80**

(86) International application number:
**PCT/JP80/00106**

(87) International publication number:
**WO 80/02624 27.11.80 Gazette 80/27**

(51) Int. Cl.⁴: **H 01 L 27/10**, H 01 L 29/78,
G 11 C 11/40

(54) **SEMICONDUCTIVE MEMORY DEVICE AND FABRICATING METHOD THEREFOR.**

(30) Priority: **18.05.79 JP 61227/79**

(43) Date of publication of application:
**20.05.81 Bulletin 81/20**

(45) Publication of the grant of the patent:
**15.01.86 Bulletin 86/03**

(84) Designated Contracting States:
**DE FR GB NL**

(56) References cited:
JP-A-52 154 378
JP-B-45 012 097
US-A-4 021 789

NEUES AUS DER TECHNIK, nr. 5, october 1,
1976, WÜRZBURG (DE), Speicherzelle, page 6
IBM TECHNICAL DISCLOSURE BULLETIN, vol.
15, nr. 4, september 1972, NEW YORK (US),
A.R. LEBLANC: "Field-effect transistor memory
circuit", pages 1292-1293

(73) Proprietor: **FUJITSU LIMITED**
**1015, Kamikodanaka Nakahara-ku**
**Kawasaki-shi Kanagawa 211 (JP)**

(72) Inventor: **TAKEMAE, Yoshihiro**
**20-5-9-301, Utsukushigaoka 1-chome Midori-ku**
**Yokohama-shi Kanagawa 227 (JP)**

(74) Representative: **Allman, Peter John et al**
**Marks and Clerk Scottish Life House Bridge**
**Street**
**Manchester M3 3DP (GB)**

Courier Press, Leamington Spa, England.

EP 0 028 654 B1

## Description

### Technical Field

The present invention relates to a semiconductor memory device, particularly one transistor- one capacitor-memory cells, and the process for producing the same.

### Background Art

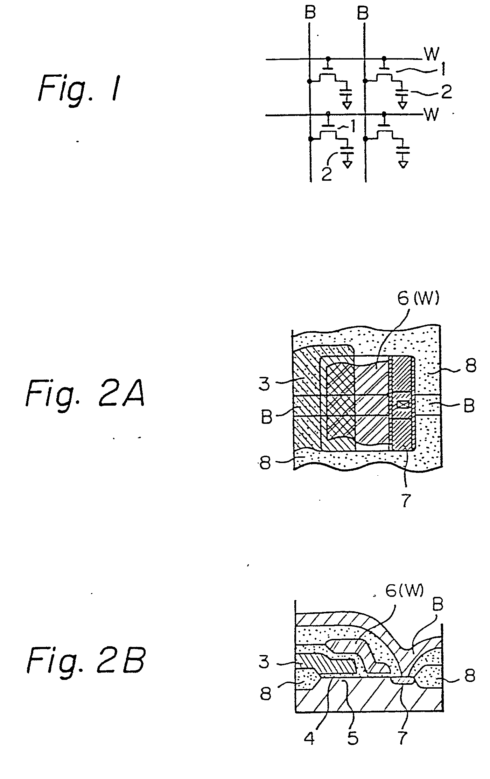

In the one transistor- one capacitor-memory cells, one bit of the memory device is constructed from one MOS transistor (1) and one memory capacitance (2) as illustrated in Fig. 1 and, therefore, the circuit of the one transistor- one capacitor-memory cells is of the simplest structure in dynamic memory devices. As illustrated in Fig. 1, the gate of each MOS transistor (1) is connected to each word line (W) and the source of each MOS transistor (1) is connected to each bit line (B). The word lines (W) and the bit lines (B) perpendicularly cross each other in the plan view of the one transistor- one capacitor-memory device. One bit of the one transistor- one capacitor-memory cells has for example, a structure, illustrated in Figs. 2A and 2B. In Figs. 2A and 2B illustrating the plan and cross sectional views, respectively, of the one bit mentioned above, the reference numerals 3, 4 and 5 indicate a capacitor electrode, an insulating film for the capacitor consisting of silicon dioxide and an electric charge-storing region of a silicon substrate, respectively.

The capacitor electrode (3), the insulating film (4) for capacitor and the charge-storing region (5) constitute an MOS diode. The capacitance of the MOS diode is that of the capacitor electrode (3), insulating film (4) and the charge-storing region (5). When the voltage applied to the capacitor electrode (3) is move than the threshold voltage of the electric charge-storing region (5), beneath the insulating film (4), the electric conductivity type of this portion is inverted and electric charges are stored. The electric charges are caused to move from the electric-charge storing portion (5) to the source (7) due to the energizing and deenergizing of the gate electrode (6). The information of "0" or "1" can be detected depending upon the movement or non-movement of the electric charges.

Each of the memory cells is surrounded by a thick insulating film (8) at the circumference thereof and is hence isolated from adjacent memory cells. The bit line (B) connects the sources (7) of the MOS transistors with each other. The gate electrode (6) of the MOS transistors is a portion of the word lines (W) shown in Figs. 2A and 2B. It is known in U.S.—A—3,996,658 to overlap the gate electrode (6) over the capacitor electode (3) in a memory cell of a semiconductor memory device.

In the memory cell having the conventional structure as explained above, an oxide film is usually used as the insulating film (4) for the capacitor. However, since the breakdown electric field of the oxide film is approximately from 2 MV/cm to 5 MV/cm, it is difficult to reduce the thickness of the oxide film from the conventional thickness, i.e. from 20 to 50 µm. Consequently, it is difficult to increase the capacitance per unit area of the insulating film higher than a certain value, which is the most serious restriction against the size reduction of the memory cell.

For the production of the memory cells, it is necessary to repeat, several times, the steps of mask alignment using the photolithographic technique. It is necessary to reckon before hand the error which occurs in the alignment of masks. The dimension of the memory cells must be increased corresponding to the error in the mask alignment.

The patterning, i.e. the defining of the borders, of the capacitor electrode (3), which consists of polycrystalline silicone, is particularly important for the dimension of the memory cells. When the patterning of the insulating film (8) for the isolation, which is carried out in the step preceding the formation step of the capacitor electrode (3), is deviated from the theoretical position of the insulating film (8), the dimension of the capacitor electrode (3), and hence the dimension of the capacitor, can be smaller than the required dimension and required capacitance, respectively. Accordingly, the insulating film (8) must be formed by taking into consideration the error of the mask alignment, and the patterning dimension of the insulating film (8) must be the minimum required dimension (F) of the insulating film plus the maximum error (R) of the mask alignment. As a result of such patterning dimension, the area of one bit of the memory cell is increased.

U.S.—A—4021789 discloses a self-aligned integrated circuit in which the isolation of each of a series of memory cells is attained by the provision of embedded thick oxide layers and field shields. In addition storage capacitors comprise a region having the opposite conductivity type to that of the substrate, a gate oxide layer and a silicon nitride layer. Word lines are connected via a ground plane to a bias potential. The word lines and the field shields are isolated from each other by an oxide layer which is formed by oxidising polycrystalline silicon. An insulating member for an MOS capacitor is identical to that for an MOS transistor and the field shields and therefore an additional insulating member for example an oxide layer is necessary for insulating the MOS capacitor, the MOS transistor and the field shields from each other. The provision of this additional insulating layer results in an undesirable increase in the minimum possible cell size. There is no disclosure of the utilization of the high dielectric constant of silicon nitride to facilitate a reduction in the cell size.

### Disclosure of the Invention

It is an object of the present invention to provide an improved semiconductor memory device of a small size, and a process for producing such a device.

According to the present invention there is provided a semiconductor memory device having a plurality of memory cells on a semiconductor substrate isolated from each other by a combination of thick insulating films and field shield layers, which films and layers lie perpendicularly crossing each other on the substrate, each memory cell comprising an MOS transistor and a memory capacitor region comprising a silicon nitride insulating film, a capacitor electrode and an electric charge storage region formed under said insulating film the electric charge storage region being formed in the substrate and having a conductivity type opposite to that of the substrate, characterised in that the insulating film of the memory capacitor region is different in its composition from an insulating film of the MOS transistor and is also used to insulate the gate electrode of the MOS transistor and the field shield layer from each other, that the insulating film is delineated to have the same pattern as the capacitor electrode formed thereover such that the insulating film and the capacitor electrode overlap the gate electrode and field shield layer and that only an insulating oxide film is formed beneath the gate electrodes and field shield layer.

Since the silicon nitride ($Si_3N_4$) film is used as the insulating film for the capacitor in the semiconductor memory device of the present invention, and further, since the dielectric constant of the silicon nitride film is from 1.5 to 2 times that of the silicon dioxide ($SiO_2$) film, it is possible to reduce the area of and increase the capacitance of the capacitor in the present invention, as compared with those using silicon dioxide film for the capacitor. The capacitance of the silicon nitride film used for the capacitor is high, while the threshold voltage (Vth) of the interface is high, because the crystal properties of the silicon nitride film are inferior to those of the silicon dioxide film with the result that the interface between the silicon nitride film and the silicon substrate is caused to be irregular. The electric charge corresponding to the threshold voltage (Vth) is not stored on the surface of the silicon substrate. Accordingly, if the threshold voltage (Vth) becomes high, the amount of the stored electric charge becomes small. The threshold voltage (Vth) is stabilized at a low level by providing the electric charge-storage region of the opposite conductivity type to that of the silicon substrate. The field shield layers may be electrically conductive lines of polycrystalline silicon operating as isolation zones, each of which cuts off two neighbouring regions of the silicone substrate. The field shield layers are in use connected to a ground potential, a back gate bias potential or an electric potential which can realize the cut off mentioned above.

The invention also provides a process for producing a semiconductor memory device of the type defined above, comprising the steps of: forming a plurality of thick insulating films on a semiconductor substrate having a first conductivity type, in such a manner that said insulating layers extend in a first direction; forming thin insulating films on said semiconductor body between said thick insulating films;

simultaneously forming first conductive layers for field shield layers and second conductive layers for word lines, in such a manner that the first and second conductive layers extend in a second direction essentially perpendicular to said first direction;

removing said thin insulating films using said first and second conductive layers as masks, thereby exposing portions of said semiconductor substrate;

introducing impurities of the second conductivity type into said exposed portions of the semiconductor substrate using the first and second conductive layers as masks, thereby forming electric charge-storage regions, and;

forming on said electric charge-storage regions insulating films of silicon nitride for capacitors, and capacitor electrodes.

Since the process of the present invention the field shield layers and the gate electrodes of the MOS transistors are simulteneously formed, and further, since the capacitors are formed in alignment with such patterning, the area of the capacitors is always constant, and is not dependent upon the patterning accuracy of capacitor electrodes. Although it is necessary in the conventional process to calculate the mask alignment error (R), in addition to the minimum required dimension (F) of the insulating film, only the minimum required dimension (F) is sufficient in the present invention for patterning the spaces between the field shield layers and the gate electrode, on which spaces the insulating films for capacitors are later formed. In addition, the impurities having a conductivity type opposite to that of the substrate are introduced in alignment with the patterning of the first and second conductive masks, into the portions of the substrate where the capacitors are to be formed and, therefore, a silicon nitride film having a high dielectric constant can be used as the insulating film for the capacitor. Accordingly, the capacitance per unit area of the memory cells is high. The field shield layers are simultaneously formed with the production of the gate electrodes. In addition, the impurities having a conductivity type opposite to that of the substrate are introduced, by self alignment, into the portions of the substrate where the capacitors are to be formed. Furthermore, the capacitor electrodes are formed on these regions. Accordingly, no additional steps over those of the conventional process are added in the production process described hereinabove.

Brief Description of Drawings

Fig. 1 illustrates an example of a circuit of a one transistor- one capacitor-memory cell.

Figs. 2A and 2B illustrate, respectively, a plan view and a cross sectional view of a conventional one transistor-one capacitor-memory cell.

Figs. 3A, 3B and 3C illustrate, respectively, a plan view, a cross sectional view along line B—B in Fig. 3A and cross sectional view along line C—C in Fig. 3A of a memory cell according to an embodiment of the present invention.

Figs. 4A through 4E illustrate production steps of a memory cell according to an embodiment of the process of the present invention.

Best Mode to Carry Out the Invention

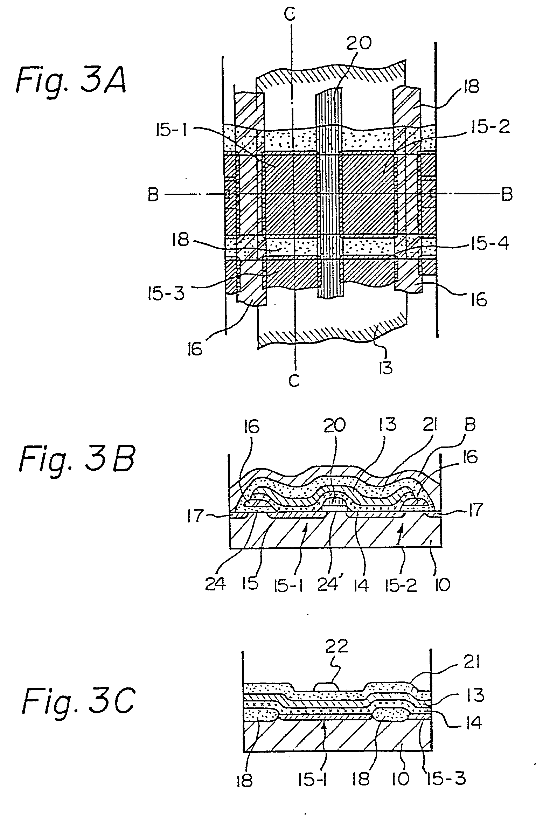

An embodiment of the one transistor- one capacitor-memory cells, according to the present invention is illustrated hereinafter with reference to Figs. 3A, 3B and 3C. In Fig. 3A the plan view of the memory cell, and in Figs. 3B and 3C the cross sectional views of the memory cell in the bit line direction and in the word line direction, respectively, are illustrated. The memory capacitance region comprises the capacitor electrode (13), the insulating film (14) consisting of silicon nitride film and the diffusion layer, i.e. the electric charge-storing region (15) having the conductivity type (second conductivity type) opposite to that (first conductivity type) of the silicone substrate (10).

In Fig. 3B, there are illustrated two bits of the memory cells (15—1 and 15—2) which are arranged in the bit line direction, and these memory cells are isolated from each other by the field shield layer (20) consisting of polycrystalline silicone and positioned between the memory cells. Two bits of the memory cells (15—1 and 15—3, Fig. 3A) arranged in the word line direction are isolated from each other by the thick insulating film (18). The word lines (16) comprise portions, which constitute gate electrodes of MOS transistors, and portions, which electrically connect the gate electrodes of adjacent transistors with each other. The latter portions, i.e. electrically conducting lines, extend on the thick insulating film (18) and the former portions, i.e. the gate electrodes, extend under the insulating film (14) of thin silicon nitride.

On the capacitor electrode (13) of the memory cells isolated from each other as described hereinabove, an insulating film (21) is deposited, and apertures exposing the source regions (17) of the MOS transistors are formed through the insulating film (21). Bit lines (22) are then formed on the insulating film (21), which bit lines connect the source regions (17) of the memory cells with each other.

In the memory cell described above, the area of the electric charge-storing region (15) is slightly greater than the area of the rectangular surface region which is surrounded by:

a pair of the thick insulating films (not shown) extending in a first direction (the bit line direction);

a gate electrode (16) of a MOS transistor extending in a second direction (the word line direction), and;

a field shield layer (20) extending in the second direction.

These insulating films, the gate electrode and the field shield layer are collectively referred to as the isolating boundary.

In addition, the insulating film (14) for the capacitor and the capacitor electrode (13) completely covers the surface region of silicon substrate surrounded by the insulating boundary, and the ends of the capacitor electrode (13) and the insulating film (14) terminate on the insulating boundary. Accordingly, the patterning accuracy of the capacitor electrode (13) does not determine the amount of electric charge applied from the electrode (13) to the insulating film (14), but merely determines the ends of the electrode (13).

The insulating film (24') beneath the field shield layer (20) has the same thickness as and consists of the same material as those of the gate insulating film (24). Accordingly, the insulating film (24') can be formed simultaneously with the gate insulating film (24) and hence no additional step is required for the formation of the insulating film (24') as compared with the production of an MOS transistor.

The thickness of the thick insulating films (18) and the insulating films (14) of silicon nitride is preferably from 500 to 2000 nm and from 20 to 50 nm, respectively. The dimension of the individual electric charge-storing region or the surface area of individual insulating films (14) is such that the capacitance of the silicon nitride films (14) is 0.02 PF at the minimum in 64 k bit memory cells.

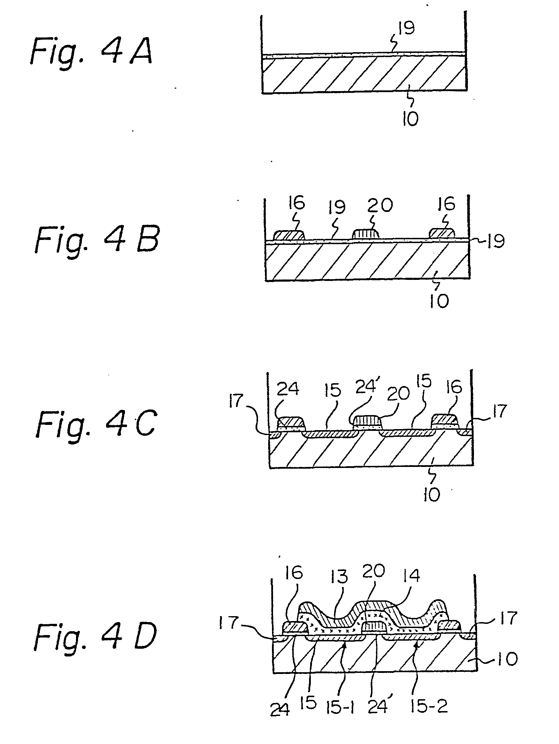

An embodiment of the process according to the present invention is hereinafter explained with reference to Figs. 4A through 4E illustrating the production steps in the sequence thereof. Figs. 4A through 4E are cross drawings in the bit line direction, which are similar to Fig. 3B.

First, the thick insulating films (18) (c.f. Figs. 3A and 3B, not shown in Figs. 4A through 4E) are formed on a silicon substrate (10) for the isolation of memory cell regions along the first direction (the bit line direction) and, then, thin insulating films (19) (Fig. 4A) are formed on the portions of the silicon substrate where the thick insulating films (18) have not been formed. The thick insulating films (18) can be formed by a known local oxidation process, while the thin insulating films (19) of silicon dioxide can be formed by a known thermal oxidation process.

A polycrystalline silicon layer is subsequently deposited by a CVD process on the silicon substrate (10), on which the insulating films (18) and (19) are formed, and is patterned to simultaneously form the word lines (16) including gate electrodes and the field shield layers (20) as illustrated in Fig. 4B. The word lines (16) and the field shield layers (20) extend in the second direction (the word line direction), which is essentially perpendicular to the first direction, and extend over the thick insulating films (18) (not shown).

Subsequently, the insulating film (19) exposed as shown in Fig. 4B is removed by etching and, thereafter, the diffusion layers (15) for the storage of electric charges and source regions (17) of MOS transistors are simultaneously formed by introducing impurities having the second conductivity type, or a conductivity type opposite to that (the first conductivity type) of the silicon substrate (10), into the silicon substrate exposed by the removal of the insulating film (19). For the introduction of the impurities, the diffusion process or the ion implantation process can be used.

Subsequently, a thin layer of silicon nitride and a polycrystalline silicon layer are successively deposited over the silicon substrate (10) and are patterned as illustrated in Fig. 4D, so as to form the silicon nitride insulating film (14) for the capacitor and the polycrystalline silicon capacitor electrode (13) of the two adjacent memory cells (15—1 and 15—2). The patterning accuracy of the silicon nitride insulating film (14) and the polycrystalline silicon capacitor electrode (13) do not exert any influence on the capacitance of the thin layer of silicon nitride. It is permitted to position between each diffusion layer (15) and each silicon nitride insulating film (14) a thin film (not shown) of silicon dioxide. The thickness of this thin film of silicon dioxide should be as thin as possible, because the thickenss of the capacitor is increased due to the thin film of silicon dioxide.

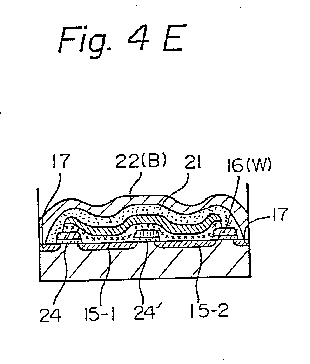

Subsequently, as illustrated in Fig. 4E, an insulating film (21) is deposited on the entire surface of the silicon substrate subjected to the production steps illustrated in Figs. 4A through 4D, and apertures are then opened through the insulating film (21) at the source regions (17) of MOS transistors. Aluminum is subsequently deposited on the insulating film (21) by an evaporation or sputtering process and patterned to form the bit lines (B) including the electrodes of the source regions (17).

Commercial Applicability

The present invention is industrially applicable to the production of the ICs and LSIs, as the ICs and LSIs have a reduced size and are more highly integrated than in the conventional ICs and the like, because the one transistor- one capacitor-memory cell is provided with the optimum structure for high integration due to the silicon nitride film for the capacitor and the field shield layers, and further such cells can be produced as simply as in the conventional production steps of the one transistor- one capacitor-memory cell.

Obviously the present invention can be applied to any of the memory cells, in which the transfer and storage of electric charges are realized in the P or N channel (P or N conductivity type diffusion layer).

**Claims**

1. A semiconductor memory device having a plurality of memory cells on a semiconductor substrate (10) isolated from each other by a combination of thick insulating films (18) and field shield layers (20), which films and layers lie perpendicularly crossing each other on the substrate, each memory cell comprising an MOS transistor and a memory capacitor region comprising a silicon nitride insulating film (14), a capacitor electrode (13) and an electric charge storage region (15) formed under said insulating film (14) the electric charge storage region (15) being formed in the substrate (10) and having a conductivity type opposite to that of the substrate, characterised in that the insulating film (14) of the memory capacitor region is different in its composition from an insulating film (21) of the MOS transistor and is also used to insulate the gate electrode (16) of the MOS transistor and the field shield layer (20) from each other, that the insulating film (14) is delineated to have the same pattern as the capacitor electrode (13) formed thereover such that the insulating film (14) and the capacitor electrode (13) overlap the gate electrode (16) and field shield layer (20) and that only an insulating oxide film (24, 24') is formed beneath the gate electrodes (16) and field shield layer (20).

2. A semiconductor memory device according to claim 1, characterised in that a relatively thin oxide layer is formed between the insulating film (14) and the charge storage region (15).

3. A semiconductor memory device according to claim 1 or 2, characterised in that the area of each of said electric charge-storage regions (15) is slightly greater than the area of the semiconductor substrate (10) surrounded by a pair of said thick insulating films (18) extending in a first direction, a gate electrode (16) of said MOS transistor extending in a second direction perpendicular to said first direction, and said field shield layer (20) also extending in said second direction.

4. A semiconductor memory device according to claim 3, characterised in that the silicon nitride film (14) and the capacitor electrode (13) completely cover the surface region of said semiconductor substrate (10) surrounded by said pair of said thick insulating films (18) said gate electrode (16) and said field shield layer (20).

5. A semiconductor memory device according to any preceding claim characterised in that said field shield layers (20) consist of polycrystalline silicon, and that the insulating oxide films formed between each field shield layer (20) and said semiconductor substrate (10), and said gate electrode (16) and said semiconductor substrate (10) have the same thickness.

6. A process for producing a semiconductor memory device according to claim 1, wherein each of the memory cells comprises one MOS transistor and one memory capacitor region, said process comprising the steps of:

forming a plurality of thick insulating films (18) on a semiconductor substrate (10) having a first conductivity type, in such a manner that said insulating layers extend in a first direction;

forming thin insulating films (19) on said semiconductor body (10) between said thick insulating films (18);

simultaneously forming first conductive layers (20) for field shield layers and second conductive layers (16) for word lines, in such a manner that the first and second conductive layers extend in a second direction essentially perpendicular to said first direction;

removing said thin insulating films (19) using said first and second conductive layers as masks, thereby exposing portions of said semiconductor substrate;

introducing impurities of the second conductivity type into said exposed portions of the semiconductor substrate using the first and second conductive layers as masks, thereby forming electric charge-storage regions (15), and;

forming on said electric charge-storage regions insulating films (14) of silicon nitride for capacitors, and capacitor electrodes (13).

**Revendications**

1. Dispositif de mémorisation à semiconducteur possédant plusieurs cellules de mémoire placées sur un substrat semiconducteur (10) et isolées les unes des autres par une combinaison de pellicules isolantes épaisses (18) et de couches d'écrans de champ (20), lesquelles pellicules et couches sont disposées de façon à se croiser perpendiculairement les unes par rapport aux autres sur le substrat, chaque cellule de mémoire comprenant un transistor MOS et une région de condensateur de mémorisation comprenant une pellicule isolante (14) en nitrure de silicium, une électrode de condensateur (13) et une région (15) d'emmagasinage de charge électrique qui est formée au-dessous de ladite pellicule isolante (14), la région d'emmagasinage de charge électrique (15) étant formée dans le substrat (10) et ayant un type de conductivité opposé à celui du substrat, caractérisé en ce que la pellicule isolante (14) de la région de condensateur de mémorisation est différente, du point de vue de sa composition, d'une pellicule isolante (21) du transistor MOS et est également utilisée pour isoler l'électrode de grille (16) du transistor MOS et la couche d'écran de champ (20) l'une de l'autre, en ce que la pellicule isolante (14) est tracée de façon à présenter la même configuration que l'électrode de condensateur (13) qui est formée au-dessus de manière que la pellicule isolante (14) et l'électrode de condensateur (13) soient en chevauchement sur l'électrode de grille (16) et la couche d'écran de champ (20), et en ce que seule une pellicule d'oxyde isolante (24, 24') est formée au-dessous des électrodes de grille (16) et de la couche d'écran de champ (20).

2. Dispositif de mémorisation à semiconducteur selon la revendication 1, caractérisé en ce qu'une couche d'oxyde relativement mince est formée entre la pellicule isolante (14) et la région (15) d'emmagasinage de charge.

3. Dispositif de mémorisation à semiconducteur selon la revendication 1 ou 2, caractérisé en ce que l'aire de chaque région d'emmagasinage de charge électrique (15) est légèrement plus grande que l'aire du substrat semiconducteur (10) entouré par une paire desdites pellicules isolantes épaisses (18) s'étendant suivant une première direction, une électrode de grille (16) dudit transistor MOS s'étendant dans une deuxième direction perpendiculaire à la première, et ladite couche d'écran de champ (20) s'étendant également dans ladite deuxième direction.

4. Dispositif de mémorisation à semiconducteur selon la revendication 3, caractérisé en ce que la pellicule de nitrure de silicium (14) et l'électrode de condensateur (13) couvrent complètement la région superficielle dudig substrat semiconducteur (10) qui est entourée par ladite paire desdites pellicules isolantes épaisses (18), ladite électrode de grille (16) et ladite couche d'écran de champ (20).

5. Dispositif de mémorisation à semiconducteur selon l'une quelconque des revendications précédentes, caractérisé en ce que lesdites couches d'écrans de champ (20) sont constituées en silicium polycristallin et en ce que les pellicules d'oxyde isolantes, formées entre chaque couche d'écrans de champ (20) et ledit substrat semiconducteur (10), ladite électrode de grille (16) et ledit substrat semiconducteur (10) ont la même épaisseur.

6. Procédé de production d'un dispositif de mémorisation à semiconducteur selon la revendication 1, où chacune des cellules de mémoire comprend un transistor MOS et une région de condensateur de mémorisation, ledit procédé comprenant les opérations suivantes:

— former plusieurs pellicules isolantes épaisses (18) sur un substrat semiconducteur (10) possédant un premier type de conductivité, de manière que lesdites couches isolantes s'étendent suivant une première direction;

— former des pellicules isolantes minces (19) sur ledit corps semiconducteur (10) entre lesdites pellicules isolantes épaisses (18);

— former simultanément des premières couches conductrices (20) destinées à servir de couches d'écrans de champ et des deuxièmes couches conductrices (16) destinées à servir de lignes de mot, de telle manière que les premières et les deuxièmes couches conductrices s'étendent suivant une deuxième direction sensiblement perpendiculaire à ladite première direction;

— enlever lesdites pellicules isolantes minces (19) en utilisant comme masques lesdites premières et lesdites deuxièmes couches conductrices, de manière à exposer des parties dudit substrat semiconducteur;

— introduire des impuretés du deuxième type de conductivité dans lesdites parties exposées du substrat semiconducteur en utilisant comme masques les premières et les deuxièmes couches conductrices, de manière à former des régions (15) d'emmagasinage de charge électrique; et

— former sur lesdites régions d'emmagasinage de charge électrique des pellicules isolantes (14) en nitrure de silicium destinées à des condensateurs, et des électrodes de condensateur (13).

**Patentansprüche**

1. Halbleiter-Speichervorrichtung mit einer Vielzahl von Speicherzellen auf einem Halbleitersubstrat (10), die voneinander durch eine Kombination von dicken Isolationsfilmen (18) und Feldabschirmschichten (20) isoliert sind, welche Filme und Schichten einander senkrecht kreuzend auf dem Substrat liegen, wobei jede Speicherzelle einen MOS-Transistor und einen Kondensatorbereich umfaßt, mit einem isolierenden Film (14) aus Siliziumnitrid, einer Kondensatorelektrode (13) und einem elektrischen Ladungsspeicherbereich (15), der unter dem genannten isolierenden Film (14) gebildet ist, wobei der elektrische Ladungsspeicherbereich (15) auf dem Substrat (10) gebildet ist und einen Leitfähigkeitstyp hat, der demjenigen des Substrats entgegengesetzt ist, dadurch gekennzeichnet, daß der isolierende Film (14) des Speicherkondensatorbereichs in seiner Zusammensetzung anders als ein isolierender Film (21) des MOS-Transistors ist und auch dazu verwendet wird, die Gateelektrode (16) des MOS-Transistors und die Feldabschirmschicht (20) voneinander zu trennen, daß der isolierende Film (14) angerissen wird, um dasselbe Muster wie die Kondensatorelektrode (13) zu haben, die darüber gebildet ist, so daß der isolierende Film (14) und die Kondensatorelektrode (13) die Gateelektrode (16) und die Feldabschirmschicht (20) überlappen und daß lediglich ein isolierender Oxidfilm (24, 24') unterhalb der Gasteelektroden (16) und der Feldabschirmschicht (20) gebildet ist.

2. Halbleiter-Speichervorrichtung nach Anspruch 1, dadurch gekennzeichnet, daß eine relativ dünne Oxidschicht zwischen dem isolierenden Film (14) und dem Ladungsspeicherbereich (15) gebildet ist.

3. Halbleiter-Speichervorrichtung nach Anspruch 1 oder 2, dadurch gekennzeichnet, daß das Gebiet von jedem der genannten elektrischen Ladungsspeicherbereiche (15) ein wenig größer als das Gebiet des Halbleitersubstrats (10) ist, das durch ein Paar der dicken isolierenden Filme (18) umgeben ist, die sich in einer ersten Richtung erstrecken, eine Gateelektrode (16) des genannten MOS-Transistors sich in einer zweiten Richtung senkrecht zu der genannten ersten Richtung erstreckt und die genannte Feldabschirmschicht (20) sich ebenfalls in der genannten zweiten Richtung erstreckt.

4. Halbleiter-Speichervorrichtung nach Anspruch 3, dadurch gekennzeichnet, daß der Siliziumnitridfilm (14) und die Kondensatorelektrode (13) den Oberflächenbereich des genannten Halbleitersubstrats (10), der durch das genannte Paar der genannten dicken isolierenden Filme (18), die genannte Gateelektrode (16) und die genannte Feldabschirmschicht (20) umgeben ist, vollständig bedecken.

5. Halbleiter-Speichervorrichtung nach einem der vorhergehenden Ansprüche, dadurch gekennzeichnet, daß die genannten Feldabschirmschichten (20) aus polykristallinem Silizium bestehen und daß die isolierenden Oxidfilme, die zwischen jeder Feldabschirmschicht (20) und dem genannten Halbleitersubstrat (10) gebildet sind, und die genannte Gateelektrode (16) und das genannte Halbleitersubstrat (10) dieselbe Dicke haben.

6. Verfahren zur Herstellung einer Halbeiter-Speichervorrichtung nach Anspruch 1, bei welchem jede der Speicherzellen einen MOS-Transistor und einen Speicherkondensatorbereich umfaßt, mit den folgenden Verfahrensschritten:

Bildung einer Vielzahl von dicken isolierenden Filmen (18) auf einem Halbleitersubstrat (10) von einem ersten Leitfähigkeitstyp, auf solch eine Art, daß die genannten Schichten sich in einer ersten Richtung erstrecken;

Bildung dünner isolierender Filme (19) auf dem genannten Halbleiterkörper (10) zwischen den dicken isolierenden Filmen (18); gleichzeitige Bildung erster leitender Schichten (20) als Feldabschirmschichten und zweiter leitender Schichten (16) als Wortleitungen, auf solch eine Art, daß die ersten und zweiten leitenden Schichten sich in einer zweiten Richtung im wesentlichen senkrecht zu der genannten ersten Richtung erstrecken;

Entfernung der genannten dünnen isolierenden Filme (19) unter Verwendung der ersten und zweiten leitenden Schichten als Masken, wodurch Teile des genannten Halbleitersubstrats exponiert werden;

Einführung von Verunreinigungen des zweiten Leitfähigkeitstyps in die genannten exponierten Abschnitte des Halbleitersubstrats, unter Verwendung der ersten und zweiten leitenden Schichten als Masken, und dadurch Bildung elektrischer Ladungsspeicherbereiche (15); und,

Bildung von isolierenden Filmen (14) aus Siliziumnitrid auf den genannten elektrischen Ladungsspeicherbereichen für Kondensatoren und Kondensatorelektroden (13).

Fig. 1

Fig. 2A

Fig. 2B

1

Fig. 3A

Fig. 3 B

Fig. 3C

*Fig. 4 A*

*Fig. 4 B*

*Fig. 4 C*

*Fig. 4 D*

# Fig. 4 E